# FASCICULE DE BREVET EUROPEEN

(11) **EP 1 573 802 B1**
(45) Date de publication et mention de la délivrance du brevet: **26.11.2008**
(21) Numéro de dépôt: 03799651.9
(22) Date de dépôt: 19.12.2003
(51) Int. Cl.: H01L 21/762, H01L 21/311

(54) **PROCEDE DE REALISATION DE CAVITES DANS UNE PLAQUE DE SILICIUM**
HERSTELLUNG VON HOHLRÄUMEN IN EINER SILIZIUMSCHEIBE
METHOD OF THE PRODUCTION OF CAVITIES IN A SILICON SHEET

(30) Priorité: 20.12.2002 FR 0216409; 20.02.2003 US 448124 P
(43) Date de publication de la demande: 14.09.2005
(73) Titulaire: S.O.I. Tec Silicon on Insulator Technologies, 38190 Bernin (FR)
(72) Inventeur: SCHWARZENBACH, Walter, F-38330 Saint Nazaire Les Eymes (FR); MALEVILLE, Christophe, F-38660 La Terrasse (FR)
(74) Mandataire: Desormiere, Pierre-Louis
(86) Numéro de dépôt international: PCT/FR2003/003820
(87) Numéro de publication internationale: WO 2004/059725

(56) Documents cités:
- FR-A- 2 700 065
- FR-A- 2 795 554
- US-A- 4 956 314
- US-A1- 2001 050 413
- US-B1- 6 171 923
- PATENT ABSTRACTS OF JAPAN vol. 018, no. 419 (E-1589), 5 août 1994 (1994-08-05) -& JP 06 132262 A (HITACHI LTD), 13 mai 1994 (1994-05-13)

## Description

### Domaine technique et art antérieur

L'invention concerne le domaine de la réalisation de composants ou d'éléments semiconducteurs, en particulier à partir de composants ou éléments de type SOI (abréviation de Silicon on Insulator, ou Silicium sur Isolant).

Le document FR2700065 décrit un procédé de fabrication d'une structure silicium sur isolant comportant des étapes d'implantation d'ions oxggène et bore. Une structure SOI comporte une couche de silicium, dans laquelle se trouvent les composants proprement dits, et sous laquelle est réalisée une couche enterrée d'isolant, par exemple du dioxyde de silicium. Cette dernière constitue une isolation vis-à-vis des courants parasites et des charges provenant de particules ionisées. Elle permet aussi une bonne isolation de composants voisins réalisés dans la même couche de silicium, et notamment une diminution sensible des capacités parasites entre de tels composants voisins. Elle repose elle-même sur un substrat en silicium, qui joue le rôle de support mécanique.

Dans certains cas ou certaines applications, on souhaite réaliser une ou plusieurs cavités dans un substrat en silicium ou en matériau semi-conducteur.

Par cavité, on entend un volume évidé surplombé par une couche de matériau semi-conducteur.

Il y a actuellement en outre un besoin de composants ou d'éléments ou de structures présentant de telles cavités.

### Exposé de l'invention

L'invention a tout d'abord pour objet un procédé de réalisation d'une structure semiconductrice, selon la revendication 1.

Une telle structure peut être réalisée à partir d'une structure SOI.

Selon l'invention, la vitesse de gravure de la couche d'isolant, après que celui-ci ait subi une implantation atomique, est plus importante que la vitesse de gravure d'un isolant vierge.

L'invention permet donc de définir des régions ou des zones de la couche d'isolant ayant des vitesses de gravure différentes.

L'implantation atomique peut être réalisée à travers toute l'épaisseur de la couche d'isolant, ou à travers une partie seulement de cette couche, formant alors une partie supérieure d'isolant traversée par les ions et une partie inférieure d'isolant non traversée par les ions.

Au moins un trou peut être formé dans la couche superficielle de silicum, débouchant dans la couche d'isolant, par exemple à l'intérieur d'une zone traversée par l'implantation atomique, ou à la limite d'une zone traversée par l'implantation atomique et d'une zone non traversée par l'implantation atomique, ou dans une zone de forme concave, convexe ou polygonale, et traversée par l'implantation atomique.

Le matériau isolant peut être par exemple choisi parmi le dioxyde de silicium (Si02), le nitrure de silicium (Si3N4), le diamant, le saphir, l'oxyde de hafnium (Hf02), l'oxyde de zirconium (ZrO2), l'alumine (Al203), l'oxyde de lanthane (La203), l'oxyde d'ytterbium (Y203).

L'étape de gravure étant réalisée à l'aide d'un acide, mais peut aussi être une étape de gravure sèche ou humide.

L'invention concerne également une structure semiconductrice selon la revendication 14.

La zone d'implantation atomique selon la revendication 14 peut, par exemple, avoir dans un plan parallèle au plan moyen de ladite couche isolante enterrée une forme concave ou convexe ou encore être de forme polygonale. Toute autre forme peut être réalisée.

Une cavité peut être formée dans la couche d'isolant. Par exemple, une partie au moins de ladite cavité est formée dans une portion de la couche d'isolant traversée par les ions de l'implantation atomique.

Cette cavité peut être par exemple de forme cylindrique, ou semi-cylindrique. D'autres formes peuvent être réalisées telles que des formes ayant, selon un plan parallèle au plan moyen de la couche d'isolant, une section au moins partiellement elliptique et/ou au moins partiellement polygonale.

Selon un autre aspect, ladite cavité comporte une première zone ayant un premier diamètre, ou une première dimension maximale ou caractéristique, et une deuxième zone, ayant un deuxième diamètre, ou une deuxième dimension maximale ou caractéristique, différent(e) du premier.

Ces première et deuxième zones peuvent être situées à des profondeurs moyennes différentes dans la couche d'isolant.

L'invention a aussi pour objet une structure semiconductrice, comportant, dans un substrat de silicium :
- une couche de silicium superficiel,
- une couche isolante enterrée, en un matériau isolant, formée sous la couche superficielle de silicium,
- une cavité, formée dans la couche d'isolant, cette cavité comportant une première zone ayant un premier diamètre, ou une première dimension maximale ou caractéristique, et une deuxième zone, ayant un deuxième diamètre, ou une deuxième dimension maximale ou caractéristique, différent(e) du premier.

Ces deux zones peuvent être situées à une même profondeur dans la couche d'isolant, ou à des profondeurs moyennes différentes dans la couche d'isolant.

### Brève description des figures

- la figure 1 représente un substrat SOI avec une implantation d'ions dans le substrat,
- les figures 2A à 2C représentent différentes étapes d'un procédé selon l'invention,
- les figures 3A à 3C représentent différentes vues de dessus de structures obtenues à l'aide d'un procédé selon l'invention,
- la figure 4 est une vue en perspective de la structure représentée en vue de dessus sur la figure 3B,
- les figures 5 et 6 représentent une vue en coupe et une vue en perspective d'une structure obtenue à l'aide d'un procédé selon l'invention.

### Description détaillée de modes réalisation de l'invention.

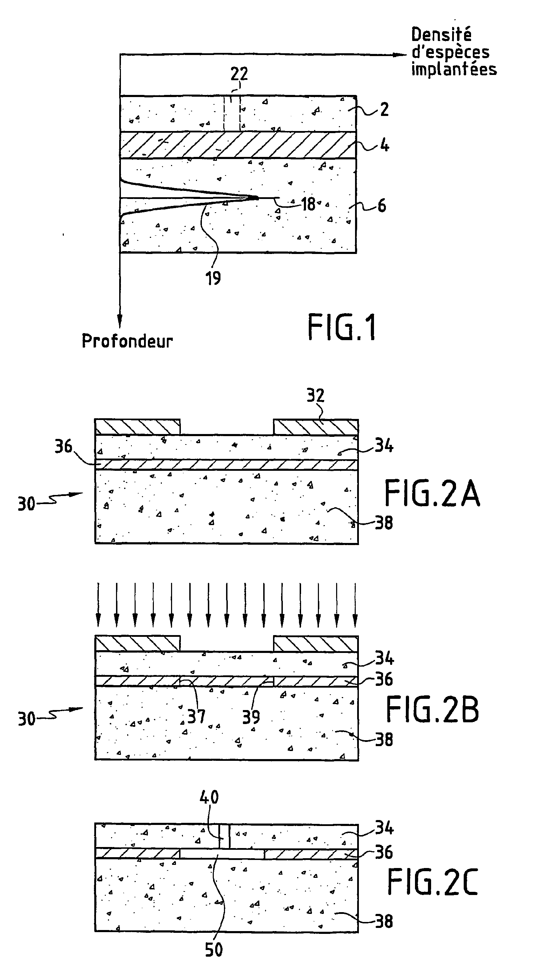

La figure 1 représente schématiquement un substrat SOI dans lequel une implantation atomique a été réalisée.

Une telle structure SOI comporte une couche 2 de silicium, de préférence monocristallin, dans laquelle peuvent être réalisés les composants proprement dits, et sous laquelle est formée une couche enterrée 4 d'un isolant, par exemple de l'oxyde de silicium.

Cette couche isolante 4 constitue une isolation vis-à-vis des courants parasites et des charges provenant de particules ionisées. Elle permet aussi une bonne isolation de composants voisins réalisés dans la même couche de silicium 2, et notamment une diminution sensible des capacités parasites entre de tels composants voisins. Elle repose elle-même sur un substrat 6 en un matériau choisi parmi les matériaux semiconducteurs, par exemple le silicium, qui joue le rôle de support mécanique.

La couche superficielle de silicium a par exemple une épaisseur d'environ 10 à 500nm ou à 1000 nm ou à 3000 nm, tandis que la couche d'isolant a par exemple une épaisseur de l'ordre de quelques centaines de nm, par exemple comprise entre 100 nm ou 200 nm et 400 nm ou 500 nm.

Ces épaisseurs, et notamment celle de la couche d'isolant, peuvent varier.

Selon l'invention, une implantation atomique de cette structure est réalisée par des espèces atomiques ou ioniques, par exemple des espèces hydrogène ou hélium, telles que H⁺ ou H₂⁺ ou He²⁺, à une profondeur située au moins dans la couche d'isolant, par exemple ou en-dessous de la couche d'isolant. Cette implantation d'espèces atomiques engendre des défauts dans la portion de cette couche qu'elle a traversée.

Ainsi, sur la figure 1, le plan 18 représente le plan moyen dans lequel les ions ont été implantés : toute la matière située au-dessus de ce plan a été traversée par le flux d'ions de l'implantation atomique. La courbe 19, centrée sur ce plan, représente la répartition moyenne des ions dans le substrat 6. Dans cet exemple, le plan 18 est situé dans le substrat 6, mais il pourrait aussi se situer dans la couche 4, auquel cas seule une portion de l'isolant 4 aurait été traversée par le trajet des ions.

Après implantation, la gravure de l'isolant enterré peut être réalisée, par exemple à l'aide d'un acide tel que l'acide fluorhydrique HF introduit par un trou 22 (représenté en traits interrompus sur la figure 1) débouchant dans la couche d'isolant. D'autres procédés de gravure peuvent être utilisés, avec les mêmes avantages, tels que par exemple la gravure sèche ou encore la gravure humide avec des composés fluorés.

Les figures 2A à 2C représentent différentes étapes d'un procédé selon l'invention. Partant d'une plaque 30 de type SOI, un masque d'implantation 32 définissant la zone à implanter est déposé (figure 2A). La profondeur de l'isolant ou de l'oxyde enterré 36 définit celle de la cavité à créer. La référence 34 désigne la couche de silicium superficielle.

L'implantation d'espèces atomiques est réalisée sur la plaque, à travers l'ouverture du masque (figure 2B), le reste du masque protégeant le SOI de ces espèces. L'énergie d'implantation peut être choisie afin d'avoir création d'une densité élevée d'espèces implantées soit dans la couche d'isolant ou d'oxyde enterré, soit à une profondeur, mesurée à partir de la surface de la couche de silicum superficiel 34, située au-delà de cet isolant ou de cet oxyde enterré.

Sur la figure 2B, la portion de la couche d'isolant 36 située entre les limites 37 et 39 (correspondant aux bords de la fenêtre du masque 32) a subi le passage des ions.

Après élimination du masque d'implantation, un trou débouchant 40 est réalisé au moyen des techniques de gravure classiques de la microélectronique (figure 2C).

Enfin, sous l'action de l'acide HF, une gravure sélective de l'isolant ou de l'oxyde enterré est réalisée au travers de ce trou débouchant, pour amener à la formation de la cavité souhaitée 50.

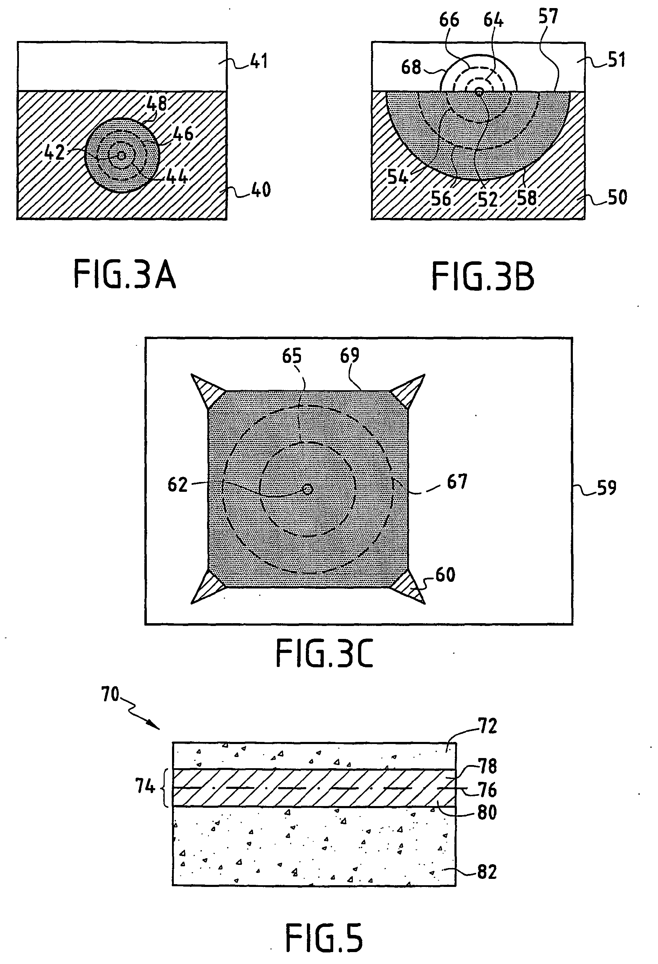

La figure 3A représente une vue de dessus d'un substrat SOI dans lequel un procédé tel que celui décrit ci-dessus a été mis en oeuvre.

Sur cette figure, comme sur les figures 3B et 3C, les zones implantées et gravées sont en gris, les zones implantées et non gravées sont en traits hachurés, les zones non implantées sont en blanc.

La référence 40 désigne la zone implantée de ce substrat, la zone non implantée étant désignée par la référence 41. Dans cette structure, le trou débouchant, pratiqué dans le substrat, est désigné par la référence 42 et est localisé au coeur de la zone implantée 40.

La gravure est réalisée progressivement dans la zone implantée et plus rapidement que dans une zone non implantée. Par exemple, sur la figure 3A, la référence 44 désigne le cylindre, ou la zone gravée, après une durée ΔT, la référence 46 la zone gravée après une durée de 2ΔT et la zone 48 la zone gravée après une durée de 3ΔT.

La figure 3B correspond au cas d'un trou débouchant créé à la limite 57 de la zone implantée 50 et de la zone non implantée 51, situées toutes deux dans la couche d'isolant ou de dioxyde de silicium .

La gravure progresse alors à la fois dans ces deux zones, 50, 51. Les vitesses de gravure dans ces deux zones sont cependant différentes l'une de l'autre. Pour cette raison, la zone gravée 54 dans la zone implantée 50 est, après une durée ΔT, plus large que la zone correspondante 64 dans la région non implantée 51.

De même, après une durée de 2ΔT, la région gravée 56 est plus large que la région gravée 66 et, après une durée 3ΔT, la région 58 est plus large que la région 68.

La figure 3C correspond au cas d'un trou débouchant créé au centre d'une zone implantée de forme concave 60 située dans la zone 59 par ailleurs non implantée, ce qui permet ainsi de créer une cavité 69 de forme carrée ou sensiblement carrée. Là encore, les références 65, 67, 69, désignent les cavités obtenues au bout de durées respectives de ΔT, 2ΔT, et 3ΔT.

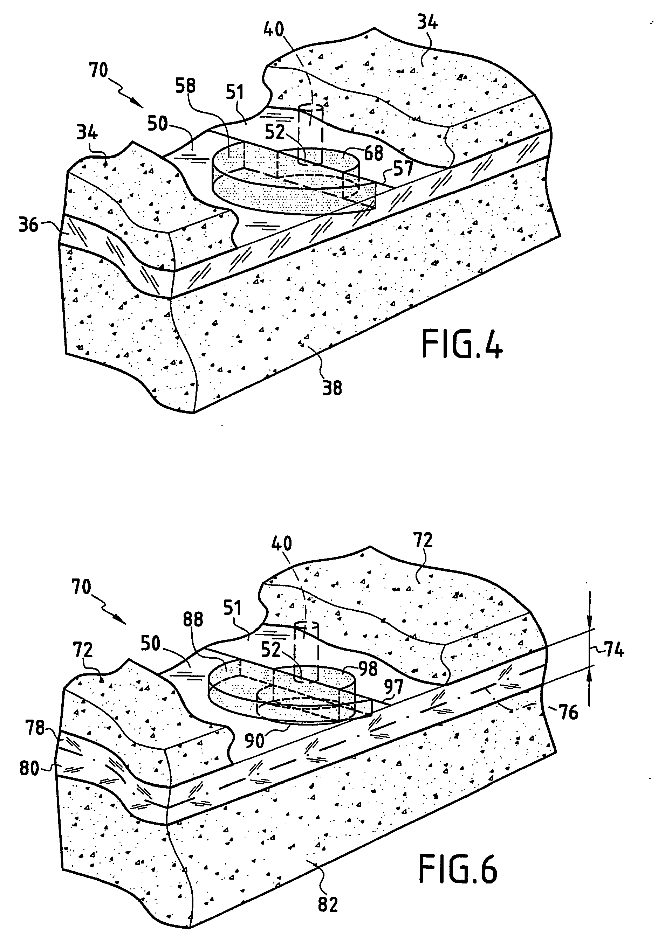

La figure 4 représente en perspective le cas de la figure 3B, les références 34, 36, 38 ayant la même signification que sur la figure 2B. Les deux demi-cylindres 58 et 68 traversent la couche d'isolant 36, suivant une direction perpendiculaire au plan de cette couche et au plan de la couche superficielle de silicium 34.

La figure 5 représente une structure SOI 70 dans laquelle la couche superficielle 72 de silicium et la couche d'isolant ou d'oxyde 74 ont été traitées par le flux d'ions seulement jusqu'à une profondeur identifiée par le plan 76 (zone ou plan d'impantation des ions). Autrement dit, la couche d'isolant ou de dioxyde de silicium est divisée en une portion supérieure 78 qui a été traversée par le flux d'ions et une portion 80 non traversée par le flux d'ions. La vitesse de gravure sera alors différente dans ces deux zones, ce qui permet de réaliser des motifs gravés présentant des variations de section ou de diamètre suivant un axe perpendiculaire au plan 76 ou au plan de la couche 72 et de la couche 78.

La figure 6 représente en perspective le résultat d'une gravure de la couche d'isolant 74. Dans la zone implantée 78, la zone gravée 88 est similaire à la zone gravée 58 de la figure 4, mais sur une épaisseur réduite par rapport à l'épaisseur totale de la couche 36. Dans la portion 80, il y a aussi gravure, mais à vitesse inférieure, d'où la zone gravée 90, située sous la zone 88 ou à une profondeur moyenne inférieure par rapport à la profondeur moyenne de la zone 88. Dans le plan de la couche 74, et de l'autre côté de la limite 97 de la zone implantée et de la zone non implantée, deux portions d'isolant, situées à deux profondeurs distinctes, sont aussi gravées (en regard de chacune des zones gravées 88 et 90), mais à une même vitesse car elles sont toutes deux dans une région non implantée. Elles ont donc toutes deux le même diamètre ou la même dimension et elles constituent la zone gravée 98.

Il est ainsi possible de réaliser des zones gravées situées à des profondeurs, ou à des profondeurs moyennes, identiques ou différentes dans la couche d'isolant d'une structure SOI, ces profondeurs étant comptées à partir de la limite supérieure de la couche d'isolant, limite qui est en contact avec la couche superficielle 34, 72 de silicium, ou à partir de la surface supérieure de la couche de silicium superficiel.

Selon un autre aspect, l'invention permet de définir dans une couche isolante telle que la couche 4 de la figure 1, des régions pour lesquelles les vitesses de gravure de cette couche sont différentes d'une région à l'autre. La couche isolante présente alors au moins une première et une deuxième régions, ayant respectivement une première et une deuxième vitesses de gravure qui sont différentes l'une de l'autre.

Selon encore un autre mode de réalisation, non représenté sur les figures, le point ou le lieu où commence la gravure peut être situé dans une zone non implantée, la gravure se propageant ensuite dans une zone implantée à une vitesse différente de la gravure dans la zone non implantée.

La combinaison des divers modes de réalisation évoqués ci-dessus permet de réaliser des zones gravées ayant des dimensions différentes suivant deux ou trois directions de l'espace. Ainsi, dans le cas de la figure 6, le diamètre ou la plus grande dimension ou la dimension caractéristique dans chaque portion ou zone gravée, ou la section de cette portion ou zone gravée, varie à la fois dans le plan de la couche 74, et suivant une direction perpendiculaire à ce plan.

On peut ainsi réaliser, dans une couche d'isolant d'une structure SOI, au moins deux zones gravées présentant un premier diamètre ou une première dimension maximale ou caractéristique, un deuxième diamètre, ou une deuxième dimension maximale, différent(e) du premier diamètre ou de la première dimension maximale ou caractéristique, et éventuellement situé(e)s à des profondeurs différentes dans la couche d'isolant.

L'une et/ou l'autre de ces zones peut être de section carrée (comme sur la figure 3C) ou être cylindrique (figure 3A) ou semi-cylindrique (figure 3B). D'autres formes peuvent encore être réalisées, en fonction de la forme du masque choisi initialement pour l'implantation et du point ou du lieu où commence la gravure dans la région implantée ou en dehors de celle-ci.

On peut aussi réaliser une cavité ayant, dans un plan parallèle ou plan moyen de la couche d'isolant, une section elliptique ou polygonale, ou en partie elliptique et en partie polygonale.

Par ailleurs, la zone d'implantation atomique peut être en fait de forme totalement quelconque, convexe, concave ou tout autre. Cette forme de la zone d'implantation atomique est liée à la forme finale de la cavité souhaitée.

Quel que soit le mode de réalisation envisagé, des composants électroniques, par exemple des transistors, peuvent ensuite être réalisés dans la couche superficielle 2, 34, 72 de silicium.

La zone gravée dans la couche d'isolant permet par exemple de réaliser une portion conductrice d'un tel composant.

Le matériau Si02 peut être utilisé en tant qu'isolant d'une structure SOI.

L'invention s'applique cependant aussi à d'autres matériaux isolants, tels que par exemple le Si3N4, le SiGe, le diamant, ou le saphir. Elle s'applique également à tout matériau à coefficient K élevé, comme ceux décrits dans le MRS Bulletin, Mars 2002, Vol. 27, No3, dans un article intitulé « Alternative Gate Dielectrics for Microelectronics » ; de tels matériaux sont par exemple l'oxyde de Haffnium (Hf02), ou l'oxyde de zirconium (ZrO2), l'alumine (Al2O3), ou encore le Y2O3 (oxyde d'ytterbium).

## Revendications

1. Procédé de réalisation d'une structure semiconductrice comportant une couche superficielle de silicium (2, 34 ,72), une couche enterrée d'isolant (4, 36, 74) et un substrat (6, 38, 82), **caractérisé en ce que** ledit procédé comprend les étapes suivantes :
- une étape d'implantation atomique de la structure semiconductrice, l'implantation étant réalisée sur une zone déterminée de la structure et à une profondeur allant au moins jusqu'à la couche d'isolant pour définir des régions de la couche d'isolant ayant des vitesses de gravure différentes, et
- une étape de gravure sélective de la couche d'isolant traversée par l'implantation atomique de manière à former une cavité dans la couche d'isolant qui s'étend sous la couche superficielle de silicium.

2. Procédé selon la revendication 1, l'implantation atomique étant réalisée à travers toute l'épaisseur de la couche d'isolant.

3. Procédé selon la revendication 1, l'implantation atomique étant réalisée à travers une partie seulement de l'épaisseur de la couche d'isolant.

4. Procédé selon l'une des revendications 1 à 3, l'étape d'implantation étant une étape d'implantation d'ions hydrogène ou d'ions hélium.

5. Procédé selon l'une des revendications 1 à 4, comportant une étape de formation d'au moins un trou (40) dans la couche superficielle de silicium, débouchant dans la couche d'isolant.

6. Procédé selon la revendication 5, le trou débouchant à l'intérieur d'une zone (40) traversée par l'implantation atomique.

7. Procédé selon la revendication 5, le trou débouchant à la limite d'une zone traversée par l'implantation atomique (50) et d'une zone non traversée par l'implantation atomique (51).

8. Procédé selon la revendication 5 ou 6, le trou débouchant dans une zone (60) de forme concave ou convexe et traversée par l'implantation atomique.

9. Procédé selon la revendication 5 ou 6, le trou débouchant dans une zone de forme polygonale et traversée par l'implantation.

10. Procédé selon la revendication 5, le trou débouchant dans une zone non traversée par l'implantation atomique.

11. Procédé selon l'une des revendications 1 à 10, le matériau isolant étant choisi parmi le dioxyde de silicium (Si02), le nitrure de silicium (Si3N4), le diamant, le saphir, l'oxyde de hafnium (HfO2), l'oxyde de zirconium (ZrO2), l'alumine (Al2O3), l'oxyde de lanthane (La2O3), l'oxyde d'ytterbium (Y2O3).

12. Procédé selon l'une des revendications 1 à 11, l'étape de gravure étant réalisée à l'aide d'un acide.

13. Procédé selon l'une des revendications 1 à 12, l'étape de gravure étant une étape de gravure sèche ou humide.

14. Structure semiconductrice, comportant, dans un substrat de silicium :
- une couche superficielle de silicium (2, 34,72),
- une couche isolante enterrée (4, 36, 78) en un matériau isolant formé sous la couche superficielle de silicium,
**caractérisé par**:
- une zone d'implantation atomique (18) réalisée dans la couche isolante ou sous cette couche isolante, et
- une cavité (50) formée au moins dans une portion de la zone d'implantation atomique réalisée dans la couche d'isolant et s'étendant latéralement sous la couche superficielle de silicium.

15. Structure semiconductrice selon la revendication 14, la zone d'implantation atomique ayant une forme concave ou convexe ou polygonale dans un plan parallèle au plan moyen de ladite couche isolante enterrée.

16. Structure semiconductrice selon la revendication 15, une partie de ladite cavité étant formée dans une portion de la couche d'isolant non traversée par les ions de l'implantation atomique.

17. Structure semiconductrice selon la revendication 15 ou 16, ladite cavité étant de forme cylindrique, ou semi-cylindrique ou de section carrée.

18. Structure semiconductrice selon l'une des revendications 15 à 17, la cavité ayant, dans un plan parallèle au plan moyen de la couche d'isolant, une section elliptique ou polygonale ou en partie elliptique et en partie polygonale.

19. Structure semiconductrice selon l'une des revendications 15 à 18, ladite cavité comportant une première zone (58, 88) ayant un premier diamètre, ou une première dimension maximale ou caractéristique, et une deuxième zone (68, 90, 98), ayant un deuxième diamètre, ou une deuxième dimension maximale ou caractéristique, différent(e) du premier.

20. Structure semiconductrice selon la revendication 19, les première et deuxième zones étant situées à des profondeurs moyennes différentes dans la couche d'isolant.

## Claims

1. A method of making a semiconductor structure comprising a surface layer of silicon (2, 34, 72), a buried insulating layer (4, 36, 74), and a substrate (6, 38, 82), **characterized in that** said method comprises the following steps:
- a step of implanting atoms into the semiconductor structure, implantation being performed on a determined zone of the structure and to a depth going at least as far as the insulating layer so as to define regions in the insulating layer with different etching speeds; and
- a step of selectively etching the insulating layer through which atoms have been implanted so as to form a cavity in the insulating layer which extends beneath the surface layer of silicon.

2. A method according to claim 2, in which atoms are implanted through the entire thickness of the insulating layer.

3. A method according to claim 1, in which atoms are implanted through a fraction only of the thickness of the insulating layer.

4. A method according to any one of claims 1 to 3, in which the implanting step is a step of implanting ions of hydrogen or ions of helium.

5. A method according to any one of claims 1 to 4, including a step of forming at least one hole (40) in the surface layer of silicon, the hole leading into the insulating layer.

6. A method according to claim 5, in which the hole (40) leads into a zone through which atoms have been implanted.

7. A method according to claim 5, in which the hole leads to the boundary between a zone (50) through which atoms have been implanted and a zone (51) through which atoms have not been implanted.

8. A method according to claim 5 or claim 6, the hole leading into a zone (60) through which atoms have been implanted, said zone being concave or convex in shape.

9. A method according to claim 5 or claim 6, the hole leading into a zone through which atoms have been implanted, said zone being polygonal in shape.

10. A method according to claim 5, the hole leading into a zone through which atoms have not been implanted.

11. A method according to any one of claims 1 to 10, the insulating material being selected from: silicon dioxide (SiO₂); silicon nitride (Si₃N₄); diamond; sapphire; hafnium oxide (HfO₂); zirconium oxide (ZrO₂); alumina (Al₂O₃); lanthanum oxide (La₂O₃); and ytterbium oxide (Y₂O₃).

12. A method according to any one of claims 1 to 11, in which the etching step is performed using an acid.

13. A method according to any one of claims 1 to 12, in which the etching step is a wet or dry etching step.

14. A semiconductor structure comprising, in a silicon substrate:
- a surface layer of silicon (2, 34, 72);
- a buried insulating layer (4, 36, 78) of insulating material formed beneath the surface layer of silicon;
**characterized by**:
- a zone (18) in which atoms have been implanted in the insulating layer or beneath said insulating layer; and
- a cavity (50) formed in at least a part of the zone in which atoms have been implanted in the insulating layer, and extending laterally beneath the surface layer of silicon.

15. A semiconductor structure according to claim 14, the zone in which atoms have been implanted being concave, or convex, or polygonal in shape in a plane parallel to the mean plane of said buried insulating layer.

16. A semiconductor structure according to claim 15, in which a portion of said cavity is formed in a part of the insulating layer through which ions for implanting atoms have not passed.

17. A semiconductor structure according to claim 15 or claim 16, in which said cavity is of cylindrical shape, or semicylindrical, or of square section shape.

18. A semiconductor structure according to any one of claims 15 to 17, in which the section of the cavity in a plane parallel to the mean plane of the insulating layer is elliptical or polygonal or partially elliptical and partially polygonal.

19. A semiconductor structure according to any one of claims 15 to 18, said cavity comprising a first zone (58, 88) having a first diameter or a first maximum or characteristic dimension, and a second zone (68, 90, 98) having a second diameter or a second maximum or characteristic dimension, different from the first.

20. A semiconductor structure according to claim 19, the first and second zones being situated at different mean depths in the insulating layer.

## Patentansprüche

1. Verfahren zum Ausbilden einer Halbleiterstruktur mit einer Oberflächenschicht aus Silizium (2, 34, 72), einer verdeckten Isolatorschicht (4, 36, 74) und einem Substrat (6, 38, 82), **dadurch gekennzeichnet, daß** das Verfahren die folgenden Schritte umfaßt:
- einen Schritt zur Atomimplantation der Halbleiterstruktur, wobei das Implantieren über einen bestimmten Bereich der Struktur und in einer wenigstens bis zu der Isolatorschicht reichenden Tiefe erfolgt, um Regionen der Isolatorschicht mit unterschiedlichen Ätzgeschwindigkeiten zu definieren, und
- einen Schritt selektiven Ätzens der von der Atomimplantation durchzogenen Isolatorschicht, so daß eine Vertiefung in der Isolatorschicht ausgebildet wird, die sich unter der Oberflächenschicht aus Silizium erstreckt.

2. Verfahren nach Anspruch 1, wobei die Atomimplantation durch die gesamte Dicke der Isolatorschicht hindurch erfolgt.

3. Verfahren nach Anspruch 1, wobei die Atomimplantation lediglich durch einen Teil der Dicke der Isolatorschicht hindurch erfolgt.

4. Verfahren nach einem der Ansprüche 1 bis 3, wobei der Implantationsschritt ein Schritt zur Implantation von Wasserstoffionen oder Heliumionen ist.

5. Verfahren nach einem der Ansprüche 1 bis 4, mit einem Schritt zur Ausbildung wenigstens eines Lochs (40) in der Oberflächenschicht aus Silizium, das in die Isolatorschicht mündet.

6. Verfahren nach Anspruch 5, wobei das Loch in einen von der Atomimplantation durchzogenen Bereich (40) mündet.

7. Verfahren nach Anspruch 5, wobei das Loch an der Grenze zwischen einem von der Atomimplantation durchzogenen Bereich (50) und einem von der Atomimplantation nicht durchzogenen Bereich (51) ausmündet.

8. Verfahren nach Anspruch 5 oder 6, wobei das Loch in einen von der Atomimplantation durchzogenen Bereich (60) konkaver oder konvexer Form mündet.

9. Verfahren nach Anspruch 5 oder 6, wobei das Loch in einen von der Implantation durchzogenen Bereich polygonaler Form mündet.

10. Verfahren nach Anspruch 5, wobei das Loch in einen von der Atomimplantation nicht durchzogenen Bereich mündet.

11. Verfahren nach einem der Ansprüche 1 bis 10, wobei das Isolationsmaterial aus Siliziumdioxid (SiO₂), Siliziumnitrid (Si₃N₄), Diamant, Saphir, Hafniumoxid (HfO₂), Zirkoniumoxid (ZrO₂), Aluminiumoxid (Al₂O₃), Lanthanoxid (La₂O₃), Ytterbiumoxid (Y₂O₃) ausgewählt ist.

12. Verfahren nach einem der Ansprüche 1 bis 11, wobei der Ätzschritt mit Hilfe einer Säure durchgeführt wird.

13. Verfahren nach einem der Ansprüche 1 bis 12, wobei der Ätzschritt ein Trocken- oder Naßätzschritt ist.

14. Halbleiterstruktur, die in einem Siliziumsubstrat folgendes umfaßt:
- eine Oberflächenschicht aus Silizium (2, 34, 72),
- eine verdeckte Isolationsschicht (4, 36, 78) aus einem unter der Oberflächenschicht aus Silizium gebildeten Isolationsmaterial,
**gekennzeichnet durch**:
- einen Atomimplantationsbereich (18), der in der Isolationsschicht oder unter dieser Isolationsschicht ausgebildet ist, und
- eine Vertiefung (50), die wenigstens in einem Abschnitt des in der Isolatorschicht ausgebildeten Atomimplantationsbereichs gebildet ist und sich seitlich unter der Oberflächenschicht aus Silizium erstreckt.

15. Halbleiterstruktur nach Anspruch 14, wobei der Atomimplantationsbereich in einer zur Mittelebene der verdeckten Isolationsschicht parallelen Ebene eine konkave oder konvexe oder polygonale Form aufweist.

16. Halbleiterstruktur nach Anspruch 15, wobei ein Teil der Vertiefung in einem von den lonen der Atomimplantation nicht durchquerten Abschnitt der Isolatorschicht gebildet ist.

17. Halbleiterstruktur nach Anspruch 15 oder 16, wobei die Vertiefung zylinderförmig oder halbzylinderförmig ist oder einen quadratischen Querschnitt aufweist.

18. Halbleiterstruktur nach einem der Ansprüche 15 bis 17, wobei die Vertiefung in einer zur Mittelebene der Isolatorschicht parallelen Ebene einen elliptischen oder polygonalen oder teilweise elliptischen und teilweise polygonalen Querschnitt aufweist.

19. Halbleiterstruktur nach einem der Ansprüche 15 bis 18, wobei die Vertiefung einen ersten Bereich (58, 88) mit einem ersten Durchmesser, oder einer maximalen oder charakteristischen ersten Abmessung, sowie einen zweiten Bereich (68, 90, 98) mit einem zweiten Durchmesser, oder einer maximalen oder charakteristischen zweiten Abmessung aufweist, der bzw. die von dem ersten bzw. der ersten abweicht.

20. Halbleiterstruktur nach Anspruch 19, wobei der erste und der zweite Bereich in unterschiedlichen durchschnittlichen Tiefen in der Isolatorschicht gelegen sind.
